(19) Europäisches Patentamt
European Patent Office
Office européen des brevets

(11) **EP 2 679 378 A1**

(12) **EUROPEAN PATENT APPLICATION**
published in accordance with Art. 153(4) EPC

(43) Date of publication:
**01.01.2014 Bulletin 2014/01**

(51) Int Cl.:
*B29C 55/12* (2006.01)  *H05K 1/03* (2006.01)
*B29K 67/00* (2006.01)  *B29L 7/00* (2006.01)

(21) Application number: **12749575.2**

(22) Date of filing: **17.02.2012**

(86) International application number:
**PCT/JP2012/053763**

(87) International publication number:
**WO 2012/114988 (30.08.2012 Gazette 2012/35)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **21.02.2011 JP 2011034235**

(71) Applicant: **Toray Industries, Inc.
Tokyo 103-8666 (JP)**

(72) Inventors:
• **TAKAHASHI, Kenta**
**Otsu-shi**
**Shiga 5208558 (JP)**

• **HORIE, Masato**
**Otsu-shi**
**Shiga 5208558 (JP)**
• **HIGASHIOJI, Takuji**
**Otsu-shi**
**Shiga 5208558 (JP)**
• **MACHIDA, Tetsuya**
**Otsu-shi**
**Shiga 5208558 (JP)**

(74) Representative: **Kador & Partner
Corneliusstrasse 15
80469 München (DE)**

(54) **BIAXIALLY ORIENTED POLYETHYLENE TEREPHTHALATE FILM**

(57)    The present invention provides a biaxially oriented polyethylene terephthalate film which has minimal curling, has superior suitability for machining, and is an ideal base material film, and whereby dimensional changes in various steps can be reduced particularly when the film is used as a base material film for a flexible device. This biaxially oriented polyethylene terephthalate film is made using at least a polyethylene terephthalate resin, wherein the average ((nMD+nTD)2) of the refractive index nMD in the length direction of the film and the refracfive index nTD in the width direction thereof is 1.655-1.70, and the refractive index nZD in the thickness direction of the film is 1.490-1.520.

EP 2 679 378 A1

**Description**

Technical field

The present invention relates to biaxially orientated polyethylene terephthalate film with high thermal dimensional stability. The biaxially orientated polyethylene terephthalate film according to the present invention can be used effectively as base film for flexible devices. Among others, the biaxially orientated polyethylene terephthalate film according to the present invention can serve as base film that suffers from little dimensional changes (high in thermal dimensional stability) and little curling and shows high processing suitability when used in various production steps particularly for manufacturing products such as organic EL (EL stands for electroluminescence) display, electronic paper, organic EL lighting, organic solar battery, and dye-sensitized solar battery.

Background art

In recent years, attention is focused on various flexible electronic devices which are required to be lightweight, thin, or flexible in shape. For the production of flexible electronic devices, plastic films are currently used as base, instead of glass plates which have been used conventionally, but serious problems associated with thermal dimensional stability and curling can take place as a result of thermal expansion and thermal shrinkage.

Having good thermal characteristics, dimensional stability, mechanical characteristics, electric characteristics, heat resistance, and surface characteristics, biaxially orientated polyethylene terephthalate films have been in wide use as base material for various products including magnetic recording material, packaging material, electric insulation material, various photographic materials, graphic art material, and optical display material. It is considered, however, that base films for flexible devices are required to have further improved physical properties, and efforts have been made aiming to improve the characteristics of polyethylene terephthalate films by such methods as blending polyethylene terephthalate with other thermoplastic resins (see patent document 1). There is a study on a method of adding particles up to a high concentration to improve the thermal expansion reducing effect (see patent document 2). Another proposed method is to perform annealing treatment of relaxed film to reduce the degree of thermal shrinkage (see patent document 3). Proposed methods for improving dimensional stability include, for instance, increasing the proportion of rigid amorphous chains in a film structure (see patent documents 4 and 5).

Prior art documents

Patent documents

Patent document 1: Japanese Unexamined Patent Publication (Kokai) No. 2003-101166
Patent document 2: Japanese Unexamined Patent Publication (Kokai) No. 2004-35720
Patent document 3: Japanese Unexamined Patent Publication (Kokai) No. HEI 3-67627
Patent document 4: Japanese Unexamined Patent Publication (Kokai) No. HEI 10-217410
Patent document 5: Japanese Unexamined Patent Publication (Kokai) No. 2002-307550

Summary of the invention

Problems to be solved by the invention

The technique described in patent document 1, however, has the disadvantage that even if thermoplastic resin is added, polyethylene terephthalate cannot be oriented easily and the thermal expansion reducing effect (which represents the thermal dimensional stability) cannot be improved sufficiently. The technique described in patent document 2, has the disadvantage that the addition of particles to a high concentration leads to a deterioration in stretchability and the thermal expansion reducing effect (which represents the thermal dimensional stability) cannot be improved sufficiently. The technique described in patent document 3, furthermore, is intended for reducing the degree of thermal shrinkage and does not serve to develop the thermal expansion reducing effect by means of an increased degree of orientation. For the techniques proposed in patent documents 4 and 5, concrete means (production methods) are described, such as a process including biaxial stretching and subsequent stepwise cooling and a process including film production and subsequent compression, but these processes are intended to achieve stabilization by increasing the number of rigid amorphous chains through thermal crystallization or ageing treatment and therefore, fail to obtain an increased degree of orientation and thermal expansion reducing effect. Thus, as described above, it has been difficult to achieve both thermal expansion reducing effect and decreased thermal shrinkage simultaneously.

An object of the present invention is to solve the aforementioned problem and obtain biaxially orientated polyethylene terephthalate film with high thermal dimensional stability, and in particular, to provide biaxially orientated polyethylene terephthalate film that can serve as base film for flexible devices that suffers from little dimensional changes and little curling and shows high processing suitability in various manufacturing steps.

Means of solving the problems

The present invention aims to meet the aforementioned object and has the following features:

The biaxially oriented polyethylene terephthalate film according to the present invention is a biaxially oriented film containing at least polyethylene terephthalate resin and is characterized in that the average ((nMD + nTD) / 2) of the refractive index nMD in the length direction (occasionally referred to also as MD) of the film and the refractive index nTD in the width direction (occasionally referred to also as TD) of the film is 1.655 to 1.70 and that the refractive index nZD in the thickness direction (occasionally referred to also as ZD) is 1.490 to 1.520.

A preferred embodiment of the biaxially oriented polyethylene terephthalate film according to the present invention is a biaxially oriented polyethylene terephthalate film having a relation among the refractive indices in these directions as represented by the following equation.

$$\text{Equation 1:} \quad nZD \geq -0.8 \times ((nMD + nTD)/2) + 2.826$$

According to a preferred embodiment of the biaxially oriented polyethylene terephthalate film according to the present invention, the degree of thermal shrinkage at 150°C is 0 to 0.5% in both the length direction and the width direction..

According to a preferred embodiment of the biaxially oriented polyethylene terephthalate film according to the present invention, the coefficient of thermal expansion in the temperature range of 50 to 150°C is 0 to 25 ppm/°C in both the length direction and the width direction..
According to a preferred embodiment of the biaxially oriented polyethylene terephthalate film according to the present invention, a minor melting peak (T-meta) appears at 180 to 200°C.

According to a preferred embodiment of the biaxially oriented polyethylene terephthalate film according to the present invention, the ratio of the in-plane orientation coefficient (fn), which is determined from the refractive index (nMD) in the length direction of the film, refractive index (nTD) in its width direction, and refractive index (nZD) in the thickness direction of the film, to the degree of crystallinity (Xc) is 0.45 to 0.65.

According to a preferred embodiment of the biaxially oriented polyethylene terephthalate film according to the present invention, the degree of crystallinity (Xc) is 0.25 to 0.35.

According to a preferred embodiment of the biaxially oriented polyethylene terephthalate film according to the present invention, the film has a haze of 0 to 5%. The invention further relates to film for the base of flexible devices including any of the biaxially orientated polyethylene terephthalate films described above.

Effect of the invention

The present invention makes it possible to obtain a biaxially orientated polyethylene terephthalate film with high thermal dimensional stability. In particular, it provides biaxially orientated polyethylene terephthalate films that can serve as base film for flexible devices that suffer from little dimensional change and little curling and show high processing suitability in various manufacturing steps.

Description of embodiments

It is necessary for the biaxially orientated polyethylene terephthalate film according to the present invention to contain, as primary component, polyethylene terephthalate (hereinafter, occasionally referred to as PET), which is a crystalline polyester, particularly from the viewpoint of its capability to form films with high productivity, mechanical characteristics, thermal dimensional stability, electric characteristics, surface characteristics, and heat resistance. Here, the primary component is a component that accounts for 80 mass% or more of the film.

For the biaxially orientated PET film according to the present invention, it is necessary that the average ((nMD + nTD) / 2) of the refractive index nMD in the length direction of the film and the refractive index nTD in its width direction be 1.655 to 1.70. The refractive index is used as a parameter to represent the molecular orientation in a PET film, and a higher refractive index indicates a higher degree of molecular orientation in a specific direction.

If the average ((nMD + nTD) / 2) of the refractive index nMD in the length direction of a film and the refractive index nTD in its width direction is less than 1.655, the PET film is poorly oriented and its coefficient of thermal expansion is large, leading to deterioration in thermal dimensional stability and curling property. To increase the average refractive index up to above 1.70, it is necessary to stretch the film to an extremely high draw ratio. This results in frequent breakage of the film as it is stretched during its production, leading to a decrease in productivity. Furthermore, the resulting biaxially orientated PET film will be very low in rupture elongation and liable to rupture, leading to a decrease in handleability and a decrease in processability. The average ((nMD + nTD) / 2) of the refractive index nMD in the length direction of the film and the refractive index nTD in its width direction can be controlled by varying different film production conditions, of which the draw ratio, the conditions for heat treatment, and the conditions for relaxed annealing (a step for annealing a film while relaxing it) have particularly large influence. For instance, the value of ((nMD + nTD) / 2) increases with an increasing draw ratio, a decreasing temperature for the heat treatment step, or a decreasing relaxation degree during the relaxed annealing step. The value of ((nMD + nTD) / 2) is more preferably 1.657 to 1.680, still more preferably 1.662 to 1.665.

It is necessary for the biaxially orientated PET film according to the present invention to have a refractive index nZD in the thickness direction of the film of 1.490 to 1.520. If the above refractive index is less than 1.490, the PET film will suffer from a large strain on molecular chains and a large thermal shrinkage, leading to deterioration in thermal dimensional stability and curling property. An average refractive index value of 1.520 suggests that a large degree of relaxation of orientation is taking place, leading to an increase in the coefficient of thermal expansion, deterioration in thermal dimensional stability, and curling property. The value of nZD can be controlled by varying different film production conditions, of which conditions for heat treatment and conditions for relaxed annealing have particularly large influence. The value of nZD can be increased by raising the heat treatment temperature, but a higher heat treatment temperature will accelerate the relaxation of orientation, often leading to a value of ((nMD + nTD) / 2) outside the preferable range. To increase the value of nZD, it is preferable to perform relaxed annealing treatment. The relaxed annealing temperature and the degree of relaxation have particularly large influence on nZD. The value of nZD increases with an increasing relaxed annealing temperature. The value of nZD also increases with an increasing degree of relaxation. The value of nZD is more preferably 1.495 to 1.515, still more preferably 1.498 to 1.505.

It is preferable that the biaxially orientated PET film according to the present invention meet the following equation.

$$\text{Equation 1:} \qquad nZD \geq -0.8 \times ((nMD + nTD) / 2) + 2.826$$

This equation shows the relation among the refractive index nZD in the thickness direction and the refractive indices nMD and nTD in in-plane directions, and commonly, the thickness-direction refractive index nZD decreases as the refractive indices in in-plane directions are increased by stretching. However, if the value of nZD is decreased by increasing the in-plane orientation, it means that the molecular chains are suffering from a large strain, often leading to thermal shrinkage and other problems including curling. For increasing the value of nZD, on the other hand, it is commonly difficult to stretch the film in the thickness direction, and therefore, crystal growth is caused by heating. Performing crystal growth by heat treatment without controlling it appropriately will cause relaxation of in-plane orientation and allow the relaxed molecular chains to be taken into the crystals. As a result, with an increasing nZD in the above equation, the degree of in-plane orientation will decrease and the thermal dimensional stability will deteriorate. Study for the present invention found a process in which the value of nZD can be increased without a decrease in the in-plane orientation by carrying out heat treatment and relaxed annealing treatment as described below, making it possible to produce a film having both thermal dimensional stability and curling property. Thermal dimensional stability represents the tendency to resist dimensional deformation caused by heat applied during a flexible device production step, and a smaller deformation is more preferable. It is undesirable for a biaxially orientated PET film to have an excessively large coefficient of thermal expansion, because it will cause a large difference in thermal expansion between the film and a flexible device layer formed on the film, possibly leading to cracks and pinholes in the flexible device layer. An excessively large thermal shrinkage is also undesirable, because it will prevent a flexible device layer from being formed accurately on the film, and the resulting flexible device layer will suffer from deterioration in functions. Curling property of a film refers to its tendency to warp or undulate largely when heated in a flexible device production step, and the degree of warping and undulation decreases with a decreasing coefficient of thermal expansion or degree of thermal shrinkage. This means that a large thermal expansion or thermal shrinkage causes a large local deformation, leading to deterioration in curling property. Even if only either the coefficient of thermal expansion or degree of thermal shrinkage is small, the curling property can deteriorate if the other is large, as a result of large expansion or shrinkage. A biaxially orientated PET film with poor curling property will be difficult to convey through production steps or fail to serve for easy formation of a flexible device layer, leading to an inferior processing suitability.

It is preferable that the biaxially orientated PET film according to the present invention have a degree of thermal shrinkage at 150°C of 0 to 0.5% in both the length direction and the width direction. If the degree of thermal shrinkage is less than 0%, it means that the film will expand rather than shrink, and suffer from large changes in size caused by, for instance, heat applied in various steps, a deterioration in yield, and other problems such as curling and peeling from the device layer. If the aforementioned degree of thermal shrinkage is more than 0.5%, the film will suffer from large changes in size caused by, for instance, heat applied in various steps, a deterioration in yield, and other problems such as curling and peeling from the device layer. It is preferable that the degree of thermal shrinkage at 150°C be 0 to 0.3%, more preferably 0 to 0.2%, in both the length direction and the width direction. The degree of thermal shrinkage can be controlled by varying different film production conditions, of which conditions for heat treatment and conditions for annealing serve effectively for their control. For the present invention, the degree of thremal shrinkage can be controlled in the range of 0 to 0.5% if the production process is carried out in a well-designed way to prevent significant relaxation of orientation from being cause by annealing. The degree of thremal shrinkage, furthermore, increases with an increasing strain on molecular chains and has a strong correlation with nZD.

It is preferable that the biaxially orientated PET film according to the present invention have a coefficient of thermal expansion at temperatures of 50 to 150°C of 0 to 25 ppm/°C in both the length direction and the width direction. To decrease the coefficient of thermal expansion down to below 0 ppm/°C, it is necessary to stretch the film to an extremely high draw ratio. This will result in frequent breakage of a film as it is stretched during its production, leading to a decrease in productivity. Furthermore, the resulting biaxially orientated film will be very low in rupture elongation and liable to rupture, leading to a decrease in handleability and a decrease in processability. If the aforementioned coefficient of thermal expansion is more than 25 ppm/°C, on the other hand, the film will suffer from large changes in size caused by, for instance, heat applied in various steps, a deterioration in yield, and other problems such as curling, and peeling from the device layer, and deformation and subsequent breakage of the device layer. It is preferable that the coefficient of thermal expansion at temperatures of 50 to 150°C be 0 to 22 ppm/°C, more preferably 0 to 20 ppm/°C, in both the length direction and the width direction. The coefficient of thermal expansion can be controlled by varying different film production conditions, of which conditions for heat treatment and conditions for annealing serve effectively for their control. For the present invention, the coefficient of thermal expansion can be controlled in the range of 0 to 25 ppm/°C if the production process is carried out in a well-designed way to prevent significant relaxation of orientation from being cause by annealing. The coefficient of thermal expansion, furthermore, decreases with an increasing molecular orientation in an in-plane direction and has a strong correlation with $((nMD + nTD) / 2)$.

It is preferable that the biaxially orientated PET film according to the present invention have a minor melting peak temperature (T-meta), which occurs slightly below the melting point, appears at 180 to 200°C. If T-meta is less than 180°C, the structure cannot be fixed sufficiently by heat treatment and the degree of thremal shrinkage tends to deteriorate. If T-meta is more than 200°C, orientation will be relaxed extremely and the coefficient of thermal expansion tends to deteriorate. T-meta is more preferably 180 to 195°C, still more preferably 185 to 195°C. T-meta can be controlled by varying the heat fixation temperature. T-meta changes according to the type of film production machine and the film production speed and increases with an increasing heat fixation temperature.

For the biaxially orientated PET film according to the present invention, it is preferable that the ratio (fn/Xc) of the in-plane orientation coefficient (fn), which is determined from the refractive index (nMD) in the length direction of the film, refractive index (nTD) in its width direction, and refractive index (nZD) in the thickness direction of the film, to the degree of crystallinity (Xc) be 0.45 to 0.65. The coefficient of thermal expansion of a PET film has a correlation with fn, and fn depends on Xc because it represents the overall orientation in the crystal and amorphous regions. Accordingly, fn apparently increases with an increasing Xc, making it difficult to define the coefficient of thermal expansion based only on the in-plane orientation coefficient. Here, the ratio of fn to Xc can serve as a crystallinity-independent orientation parameter that can exclusively define the coefficient of thermal expansion of a polyester film. Furthermore, the value of fn/Xc has a correlation with the quantity of rigid amorphous portions, and the quantity of rigid amorphous portions increases with an increasing value of fn/Xc. Here, rigid amorphous portions refer to portions that do not move at or above the glass transition temperature. For the present invention, it is preferable to decrease the coefficient of thermal expansion by controlling the value of fn/Xc to increase the quantity of rigid amorphous portions.

If fn/Xc is less than 0.45, the rigid amorphous portions account for only a small part of the PET film, and the coefficient of thermal expansion increases, possibly leading to deterioration in thermal dimensional stability and curling property. To increase the fn/Xc ratio up to above 0.65, it is necessary to stretch the film to an extremely high draw ratio. This will possibly result in frequent breakage of the film due to stretching during its production, leading to a decrease in productivity. It is also necessary to decrease the heat treatment temperature to an extremely low level. In some cases, therefore, it is impossible to achieve adequate heat fixation, and the degree of thremal shrinkage increases, leading to deterioration in thermal dimensional stability and curling property. The fn/Xc ratio is more preferably 0.50 to 0.65, still more preferably 0.55 to 0.65. To achieve a fn/Xc ratio in the aforementioned range, it necessary to control the draw ratio, conditions for heat treatment, and conditions for relaxed annealing among other film production conditions as described later. For instance, the fn/Xc ratio increases if the draw ratio is increased. The fn/Xc ratio also increases if the degree of relaxation in the relaxed annealing step is decreased. The draw ratio is preferably 3.5 to 5.5 in both the longitudinal and transverse directions, and the temperature of heat fixation, which is performed by using a stenter after stretching, is preferably 180 to 195°C (hereinafter, the temperature may be referred to as Ths). If the heat fixation temperature is more than 195°C, the degree of relaxation in the relaxed annealing step is preferably 0.1 to 1 %.

It is preferable that the biaxially orientated PET film according to the present invention have a degree of crystallinity (Xc) of 0.25 to 0.35. The degree of crystallinity serves as a parameter representing the crystallinity of a PET film, a higher degree of crystallinity indicates that the crystal component accounts for an increased part of the film.

If the degree of crystallinity (Xc) is less than 0.25, heat fixation has not been achieved sufficiently, and a large thermal shrinkage has occurred, possibly leading to deterioration in thermal dimensional stability and curling property. If it is more than 0.35, crystals have grown and accordingly, the orientation in in-plane directions has decreased, possibly making it impossible to achieve an adequately low thermal expansion. It is more preferable that the degree of crystallinity (Xc) be 0.25 to 0.32, still more preferably 0.27 to 0.30. In achieving a degree of crystallinity (Xc) in the aforementioned range, the heat fixation temperature (Ths) and the relaxed annealing temperature have large influence among other film production conditions as described later. For instance, the degree of crystallinity (Xc) increases if the heat fixation temperature (Ths) is increased. The degree of crystallinity also increases with an increasing degree of relaxation. The heat fixation temperature (Ths) is preferably 180 to 200°C, and the temperature for the relaxed annealing step is preferably (Ths - 5) to (Ths - 15)°C. It is preferable that the biaxially orientated PET film according to the present invention have a haze value of 0 to 5%. If the haze value is more than 5%, the transparency is low, often leading to problems such as decreased efficiency in organic ELs and thin film solar batteries. The haze value is more preferably 0 to 3%, still more preferably 0 to 2%. The haze value can be controlled by varying the content of particles to be added and the average dispersed particle diameter.

For instance, the biaxially orientated PET film according to the present invention as described above is produced as follows:

First, PET is prepared. PET is produced by any of the following processes. Specifically, process (1) in which terephthalic acid and ethylene glycol, used as input materials, are subjected directly to esterification reaction to produce low molecular weight PET or oligomers, followed by condensation polymerization reaction using antimony trioxide, a titanium compound, or the like as catalysts to provide a polymer; and process (2) in which dimethyl terephthalate and ethylene glycol, used as input materials, are subjected to ester interchange reaction to produce a low molecular weight material, followed by condensation polymerization reaction using antimony trioxide, a titanium compound, or the like as catalysts to provide a polymer.

Here, the esterification reaction can progress without a catalyst, but commonly a compound such as manganese, calcium, magnesium, zinc, lithium, and titanium is used for the ester interchange reaction. In some cases, a phosphorus compound is added after the ester interchange reaction has substantially completed in order to inactivate the catalyst used for the reaction.

To make the PET film surface slippery, wear resistant, and scratch resistant, it is preferable to add inorganic particles or organic particles, including, for instance, inorganic particles such as of clay, mica, titanium oxide, calcium carbonate, kaolin, talc, wet silica, dry silica, colloidal silica, calcium phosphate, barium sulfate, alumina, and zirconia; organic particles containing components such as acrylic acid, styrene resin, heat curable resin, silicone, and imide based compounds; and those particles (so-called internal particles) separated out by, for instance, the catalyst added to the PET polymerization reaction step.

If inactive particles are to be added to PET that is used as a component of the biaxially orientated PET film according to the present invention, it is preferable to disperse a predetermined quantity of the inactive particles in the form of slurry to ethylene glycol and adding this ethylene glycol during the polymerization step. When adding inactive particles, the particles are dispersed adequately if, for instance, the particles in the form of hydrosol or alcohol sol resulting from the synthesis of the inactive particles are added without drying them. It is also effective to mix water slurry of inactive particles directly with PET pellets and kneading them in PET in a vented biaxial kneading extruder. As a method for adjusting the content of inactive particles, it is effective to first carry out the above procedure to prepare master pellets containing inactive particles at a high concentration and diluting them, at the time of film production, with a PET material substantially free of inactive particles to adjust the content of inactive particles.

Then, the pellets prepared above and PET chips, used as an input material, are dried under reduced pressure for 3 hours or more at a temperature of 180°C, and subsequently supplied, as a film component, in a nitrogen air flow or under reduced pressure to prevent a decrease in intrinsic viscosity, to an extruder heated at a temperature of 270 to 320°C, followed by extruding the material through a slit die and cooling it on a casting roll to provide an unstretched film. In doing this, it is preferable to use any of various filters such as those of sintered metal, porous ceramic, sand, or metal gauze in order to remove foreign objects and altered polymers. Furthermore, a gear pump may be provided, as required, to improve the volumetric feeding capability. When films are to be laminated, two or more extruders and manifolds or confluent blocks are used to stack a plurality of different polymer layers. It is preferable that the PET chips to be used as input material account for 0.5 to 1.5 dl/g so that film IV stay in a preferable range.

In addition, various additive including, for instance, compatibilizer, plasticizer, weathering agent, antioxidant, thermal stabilizer, lubricant, antistatic agent, brightening agent, coloring agent, electrically conductive agent, ultraviolet absorber, flame retardant, flame retardation assistant, pigment, and dye may be added as long as they do not impair the effect of the invention.

Subsequently, a sheet-like material as produced above is stretched biaxially. It is stretched in two directions, i.e., the length direction and the width direction, and subjected to heat treatment.

Typical stretching method include sequential biaxial stretching which is carried out by, for instance, stretching first in the length direction followed by stretching in the width direction; simultaneous biaxial stretching which is carried out by using a tool such as simultaneous biaxial tenter to perform stretching in the length and width directions simultaneously; and a combination of sequential biaxial stretching and simultaneous biaxial stretching. Heat treatment is performed after the stretching, but in order to control the coefficient of thermal expansion and the degree of thremal shrinkage in a range as specified for the present invention, it is preferable to perform the heat treatment effectively so that molecular chain orientation will not be relaxed as a result of excessive heat treatment.

Described in more detail below is a biaxial stretching method that uses a longitudinal stretching machine with several rollers in which an unstretched film is stretched in the vertical direction (MD stretching) by means of the difference in circumferential speed among the rollers, followed by transverse stretching (TD stretching) using a stenter.

First, the unstretched film subjected to MD stretching. With respect to the stretching temperature, the film is preferably heated by a group of heating rollers maintained preferably in the range of (Tg) to (Tg + 40)°C, more preferably in the range of (Tg + 5) to (Tg + 30)°C, and still more preferably in the range of (Tg + 10) to (Tg + 20), and after stretching in the length direction to a ratio of preferably 3.0 to 6.0, more preferably 3.0 to 5.5, still more preferably 3.5 to 5.5, and still more preferably 3.8 to 4.5, it is preferably cooled by a group cooling rollers maintained temperatures of 20 to 50°C.

Then, a stenter is used to carry out stretching in the width direction. It is preferable that a preheating zone be provided before the stretching step zone so that the MD-stretched film is preheated at a temperature higher than the cold crystallization temperature to ensure accelerated crystallization. The preheating temperature is preferably in the range from (cold crystallization temperature of MD-stretched film + 2) to (cold crystallization temperature of MD-stretched film + 10). For the present invention, it is preferable that from the viewpoint of achieving a predetermined coefficient of thermal expansion that many microcrystallites that can act as nodal points be formed in the preheating step before transverse stretching (TD stretching). Specifically, the preheating temperature is preferably 90°C to 110°C, more preferably 95°C to 100°C. The stretching temperature is preferably equal to or lower than the preheating temperature, more preferably in the range of from the preheating temperature to (preheating temperature - 20)°C, still more preferably in the range from (preheating temperature - 5) to (preheating temperature - 15)°C. The draw ratio is preferably 3.0 to 6.0, more preferably 3.5 to 5.5, and still more preferably 3.8 to 4.5.

Following this, the stretched film is maintained under tension or in a relaxed state in the width direction while being subjected to heat fixation treatment. Heat fixation treatment is carried out preferably at a heat fixation temperature (Ths) of 180 to 200°C, more preferably 180 to 195°C, and still more preferably 185 to 195°C. If Ths is less than 180°C, structure fixation will not be achieved sufficiently, leading to a small nZD and a high degree of thremal shrinkage. If Ths is more than 200°C, orientation will be relaxed excessively, leading to a small value of (nMD + nTD) / 2 and a high coefficient of thermal expansion. It is preferable that heat fixation treatment be continued for 0.5 to 10 seconds. It is preferable that the degree of relaxation for heat fixation treatment (hereinafter, occasionally referred as Rxhs) be equal to or less than three times the degree of relaxation for relaxed annealing treatment to be performed subsequently (hereinafter, occasionally referred as Rxa). The degree of relaxation is defined as the ratio of the decrease in width caused by the treatment to the width measured before the treatment, and for instance, a degree of relaxation 2% means that a width of 100 mm before treatment is decreased by 2% or 2 mm to 98 mm as a result of relaxation treatment. If Rxhs is more than three times Rxa, orientation will be relaxed excessively, leading to a decrease in the coefficient of thermal expansion. It is preferable that Rxhs be 0.1 to 9%.

Subsequently, the film is cooled to a temperature of preferably 35°C or less, more preferably 25°C or less, and wound up on a core after removing the edges. In order to increase the thermal dimensional stability, furthermore, the wound-up biaxial stretched PET film is conveyed, preferably under tension at an appropriate temperature, and subjected to relaxed annealing treatment to remove strains in the molecular structure and decrease the degree of thremal shrinkage. The temperature for relaxed annealing treatment (hereinafter, occasionally referred to a Ta) is preferably lower than the heat fixation temperature (Ths) and in the range of (Ths - 5) to (Ths - 15)°C, more preferably (Ths - 7) to (Ths - 12)°C. If Ta is more than (Ths - 5)°C, the structure fixed by heat fixation treatment tends to be relaxed again, leading to a decrease in the coefficient of thermal expansion. If Ta is less than (Ths-15)°C, strains in the molecular structure will not be removed completely by annealing treatment. The relaxed annealing treatment time is preferably 1 to 120 seconds, more preferably 5 to 90 seconds, and still more preferably 20 to 60 seconds. The degree of relaxation (Rxa) for relaxed annealing treatment is preferably 0.1 to 3%, more preferably 0.1 to 1%. If Rxa is less than 0.1%, recognizable relaxation will not take place and strains in the molecular structure will not be removed completely, failing to decrease the thermal shrinkage. If Rxa is more than 3%, orientation will be relaxed excessively and the coefficient of thermal expansion will deteriorate. A biaxial stretched PET film according to the present invention can be obtained by subjecting the film to annealing treatment while conveying it at a speed of 10 to 300 m/min.

If a simultaneous biaxial tenter used for the present invention, relaxed annealing treatment may be performed after heat fixation.

For the present invention, the PET film or rolls of the PET film may be subjected to other appropriate processing steps as required such as molding, surface treatment, lamination, coating, printing, embossing, and etching.

(Methods for measurement of properties and methods for evaluation of effects)

The methods for measurement of characteristic values and methods for evaluation of effects used for the present invention are as described below.

(1) Refractive index

Measurements were made using measuring devices as described below according to JIS-K7142 (2008). For the present invention, if the length and width directions of a film specimen are apparent, the values of nMD and nTD of the film are determined assuming those directions. In the case where a film specimen has a roughly rectangular shape but their length and width directions are not apparent, the longer side may be assumed to be in the length direction and the direction perpendicular to it may be assumed to be the width direction in making the following calculations (if a film specimen has a roughly square shape, either of the directions parallel to its sides may be assumed to be the length or width direction). The same assumption for the length and width directions of a film specimen is adopted in paragraph (2) and subsequent paragraphs for properties other than refractive index.

 o Equipment: Abbe refractometer 4T (supplied by Atago Co., Ltd.)
 o Light source: sodium D-line
 o Measuring temperature: 25°C
 o Measuring humidity: 65%RH
 o Mounting medium: methylene iodide, sulfur methylene iodide

nMD: refractive index in the length direction of a film
nTD: refractive index in the width direction of a film
nnZD: refractive index in the thickness direction of a film

$$\text{Average of refractive indices in length and width directions} = ((nMD + nTD) / 2)$$

In-plane orientation coefficient (fn) = ((nMD + nTD) / 2) - nZD

(2) Coefficient of Thermal expansion

For three specimens, measurements were made in the length direction and in the width direction under the following conditions according to JIS K7197 (1991), and their averages were calculated to determine the coefficient of thermal expansion in the length and width directions.

 o Measuring equipment: TMA/SS6000 supplied by Seiko Instruments Inc.
 o Specimen size: width of 4 mm and length of 20 mm
 o Temperature conditions: heated at 5°C/min from 30°C to 175°C which was maintained for 10 min
 o Then cooled at 5°C/min from 175°C to 40°C which was maintained for 20 min
 o Load conditions: 29.4 mN (constant)

Here, the coefficient of thermal expansion was measured for the temperature range of 150°C to 50°C during the cooling period. The coefficient of thermal expansion was calculated by the following equation.

$$\text{Thermal expansion coefficient [ppm/°C]} = 10^6 \times \{(\text{size (mm) at } 150°C - \text{size (mm) at } 50°C) / 20 \text{ (mm)}\} / (150°C - 50°C)$$

(3) Degree of thremal shrinkage at a temperature of 150°C

The degree of thremal shrinkage was measured using the following equipment under the following conditions.

> o Length measuring machine: all-purpose projector
> o Specimen size: test length of 150 mm × width of 10 mm
> o Heat treatment equipment: Geer type oven
> o Heat treatment conditions: 150°C for 30 min
> o Calculation method

Before starting heat treatment, gauge marks were made on the specimen at an interval of 100 mm. Heat treatment was carried out under the above conditions (weight of 3g, 150°C, 30 min) and the distance between the gauge marks on the heat-treated specimen was measured. The degree of thremal shrinkage was calculated from the difference between the gauge marks measured before and after the heat treatment, and used as an index to represent the thermal dimensional stability. For each film, five specimens were taken for measurement for each of the length and width directions, and evaluation was carried out based on the average of the measurements.

(4) Melting point (Tm), minor melting peak (T-meta) slightly below melting point, and degree of crystallinity (Xc)

According to JIS K7121-1987, using a differential scanning calorimeter (RDC220) and a data analysis system (Disk Station SSC/5200), both supplied by Seiko Instruments Inc., a specimen of 5 mg was put on an aluminum tray and heated from 25°C to 300°C at a heating rate of 20°C/min. The calorific value of the endothermic peak observed in the melting process was adopted as the heat of crystal melting, and the temperature at the endothermic peak was adopted as the melting point (Tm). A minute endothermic peak appearing at a temperature slightly below Tm (above 150°C and below Tm) was taken as Tmeta. (Here, Tmeta represents the heat history associated with the heat fixation temperature and therefore, and can be confirmed to be as such by checking that it is observed in the first run of DSC measurement but not in a second run that is performed after heating the specimen up to above Tm to remove the heat history.)
The degree of crystallinity (Xc) was calculated from the heat of crystal melting ($\Delta H_m$) and heat of cold crystallization ($\Delta H_c$) by the following equation:

$$Xc = (\Delta H_m - \Delta H_c) / \Delta H_m^{\ 0}$$

Here, $\Delta H_m^{\ 0}$ (heat of melting of perfect crystal of PET) is 140.10 J/g.

(5) Glass transition temperature (Tg)

The specific heat is measured using the following equipment under the following conditions according to JIS K7121 (1987).

> o Equipment: temperature-modulated DSC supplied by TA Instrument
> o Measuring conditions
> o Heating temperature: 270 to 570K (RCS cooling method)
> o Temperature calibration: melting point of high purity indium and tin
> o Temperature modulation amplitude: ±1K
> o Temperature modulation period: 60 seconds
> o Heating rate: 2 K/min
> o Specimen weight: 5 mg
> o Specimen container: open type container of aluminum (22mg)
> o Reference container: open type container of aluminum (18mg)

The glass transition temperature is calculated by the following equation.

Glass transition temperature = (extrapolated glass transition onset temperature + extrapolated glass transition end temperature) / 2

(6) Haze value of film

A specimen of 10 cm × 10 cm was cut out of a film and its haze value was measured by a fully automatic, direct reading type Haze Computer HGM-2DP(supplied by Suga Test Instruments Co., Ltd.) according to JIS K7105 (1985). Measurements were made for 10 randomly sampled specimens, and their average was adopted as the haze value of the film.

(7) Thermal dimensional stability

A specimen of width 100 mm × length 100 mm was cut out of a biaxially stretched polyethylene terephthalate film according to the present invention and used to produce a transparent electrically conductive layer - organic EL layer as described below assuming an organic flexible device, and the thermal dimensional stability was evaluated based on various measurements including surface resistivity and dimensional changes.

o (Transparent electrically conductive layer)

The chamber was evacuated to a pressure of $5 \times 10^{-4}$ Pa before starting plasma discharge, and argon and oxygen are introduced into the chamber to a pressure of 0.3 Pa (partial pressure of oxygen 3.7 mPa). Indium oxide containing 36 mass% of tin oxide (supplied by Sumitomo Metal Mining Co., Ltd., density 6.9 g/cm$^3$) was used as target, and direct current magnetron sputtering was carried out by applying electric power with a power density of 2 W/cm$^2$ to form a transparent electrically conductive layer of ITO with a thickness of 250 nm. If the biaxially orientated polyethylene terephthalate film suffers from large thermal expansion, cracking will take place in the transparent electrically conductive layer to decrease the surface resistivity. Evaluation was conducted according to the following criteria. A film is unacceptable if it is ranked as C.

AA: A transparent electrically conductive layer with a surface resistivity of less than 30 $\Omega/\square$ was formed successfully.
A: A cracked transparent electrically conductive layer with a surface resistivity of 30 $\Omega/\square$ or more and less than 50 $\Omega/\square$ was formed.
B: A considerably cracked transparent electrically conductive layer with a surface resistivity of 50 $\Omega/\square$ or more and less than 100 $\Omega/\square$ was formed.
C: The resulting film has a surface resistivity of 100 $\Omega/\square$ or more, or cannot form a transparent electrically conductive layer due to problems such as curling and width shrinkage.

o (Hole transport layer)

A solution of polyethylene dioxy thiophene - polystyrene sulfonate (PEDOT/PSS, Bytron P AI 4083, supplied by Bayer) diluted with 65% of pure water and 5% of methanol, used as coating for hole transport layer formation, was applied over the entire surface (except 10 mm edge portions) of a transparent electrically conductive layer using an extrusion coating machine to form a film with a dry film thickness of 30 nm. After the coating step, drying and heating were carried out at 150°C for 1 hour to form a hole transport layer.

o (Light emitting layer)

The hole transport layer was coated with a toluene solution containing 1 mass% of poly(N-vinyl) carbazole and 0.1 mass% of dopant iridium complex dye [Ir(ppy)$_3$] by the extrusion coating technique to form a film. Vacuum drying was carried out at 120°C for 1 hour to form a light emitting layer with a thickness of about 50 nm.

o (Electron transport layer)

The light emitting layer was coated with a 1-butanol solution containing 0.5 mass% of tris-(8-hydroxyquinoline) aluminum [Alq$_3$], an electronic transport material, also by the extrusion coating technique to form a film. Vacuum drying was carried out at 60°C for 1 hour to form an electron transport layer with a thickness of about 15 nm. An all-purpose projector was used for length measurement. Evaluation of thermal dimensional stability was conducted according to the following criteria. A film is unacceptable if it is ranked as C.

AA: An organic EL layer is formed successfully with a deformation of less than 200 $\mu$m both in the length and width directions, and the organic EL layer emits light successfully.

A: An organic EL layer is formed with a deformation of 200 $\mu$m or more and less than 500 $\mu$m at least in the length or width direction, and part of the organic EL layer has a defect.

B: The layer suffers from a deformation of 500 $\mu$m or more at least in the length or width direction, formation of creases, or uneven coating for the organic EL layer, and the organic EL layer suffers from uneven or defective light emission.

C: An organic EL layer cannot be formed due to creases or curling of the film.

(8) Curling property

A specimen of 10 cm $\times$ 10 cm was cut out of a film and left in an oven at a temperature of 150°C for 30 min. Subsequently, it is left under the conditions of a temperature of 23°C and humidity of 65%RH for 30 min, and then the state of curling at the four corners was observed. The average of measured warp (mm) at the four corners is calculated, and evaluation was conducted according to the following criteria. The curling property improves with a decrease in both coefficient of thermal expansion and degree of thremal shrinkage. A film is unacceptable if it is ranked as C.

AA: The size of warp is less than 2.5 mm.
A: The size of warp is 2.5 mm or more and less than 5 mm.
B: The size of warp is 5 mm or more and less than 10 mm.
C: The size of warp is more than 10 mm.

Examples

Embodiments of the present invention are described with reference to Examples.

(Reference Example 1)

First, 194 parts by mass of dimethyl terephthalate and 124 parts by mass of ethylene glycol were put in an ester interchange reaction apparatus and heated at a temperature of 140°C to ensure dissolution. Subsequently, 0.3 part by mass of magnesium acetate tetrahydrate and 0.05 part by mass of antimony trioxide were added while stirring the content and subjected to ester interchange reaction while distilling out methanol at a temperature of 140 to 230°C. Then, 1 part by mass of a 5 mass% solution of trimethyl phosphate in ethylene glycol (0.05 part by mass of trimethyl phosphate) was added. The addition of a solution of trimethyl phosphate in ethylene glycol acts to decrease the temperature of  the content. The stirring of the content was continued while distilling out excess ethylene glycol, until the temperature returned to 230°C. After the temperature of the content in the ester interchange reaction apparatus had reached 230°C, the content was transferred to a polymerization apparatus. After the transfer, the reaction system was heated gradually from a temperature of 230°C up to a temperature of 290°C while decreasing the pressure down to 0.1 kPa. Both the time required to reach the final temperature and the time required to reach the final pressure were adjusted to 60 min. The stirring torque in the polymerization apparatus came to a predetermined value (depending on specifications of the polymerization apparatus, the torque shown by polyethylene terephthalate with an intrinsic viscosity 0.65 in this polymerization apparatus was used as the "predetermined value") when reaction was continued for 2 hours after a final temperature and final pressure were reached (a total of 3 hours after the onset of polymerization). Here, the condensation polymerization reaction was stopped after purging nitrogen from the reaction system and restoring atmospheric pressure, and the reaction product was discharged into cold water to produce a strand, which was cut immediately to provide polyethylene terephthalate PET pellets $X_{0.65}$, which had an intrinsic viscosity of 0.65.

(Example 1)

After drying under reduced pressure at a temperature of 180°C for 3 hours, PET pellets $X_{0.65}$ with an intrinsic viscosity of 0.65 prepared in Reference example 1 was supplied to an extruder heated at a temperature of 280°C and introduced to a T-die orifice in a nitrogen atmosphere. Then, the melt was extruded from the T-die orifice in a sheet-like form to prepare a molten monolayer sheet, which was cooled and solidified by applying static electricity to bring it into close contact with a drum with a surface maintained at a temperature of 25°C, thereby providing an unstretched monolayer film.

Subsequently, the resulting unstretched monolayer film was preheated by a group of heated rollers and subjected to MD stretching to a ratio of 4.3 at a temperature of 88°C, and cooled by a group of rollers at a temperature of 25°C to provide a uniaxially stretched film. The resulting uniaxially stretched film, with its ends held by clips, was supplied to a preheating zone maintained at a temperature of 95°C in a tenter, and continuously fed to a heating zone where it was stretched 4.3 times at a temperature of 90°C in the width direction (TD direction) which was perpendicular to the length direction. Following this, heat treatment was carried out at a temperature of 190°C for 5 seconds in a heat treatment zone in the tenter and subjected to relaxation treatment by 2% in the width direction at a temperature of 190°C. Subsequently, the film was cooled uniformly down to 25°C, and the edges of the film were removed, followed by winding up on a core to provide a biaxially stretched film with a thickness of 100 μm.

While being conveyed at a speed of 30 m/min, the film was subjected to annealing treatment at a temperature of 180°C for 30 seconds to achieve 1% relaxation, thereby providing a biaxially stretched polyethylene terephthalate film.

Evaluation of the resulting biaxially oriented polyethylene terephthalate film showed that it had characteristics including considerably high thermal dimensional stability and curling property as given in Table.

(Example 2)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially oriented polyethylene terephthalate film suggested that it had characteristics including high thermal dimensional stability as a result of a slightly high heat treatment temperature (occasionally referred to as Ths) and anneal temperature (occasionally referred to as Ta) which led to a smaller value of (nMD + nTD / 2) as shown in Table.

(Example 3)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially oriented polyethylene terephthalate film suggested that it had characteristics including high thermal dimensional stability as a result of a slightly high Ths which led to a smaller value of (nMD + nTD / 2) as shown in Table.

(Example 4)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially oriented polyethylene terephthalate film suggested that it had characteristics including good curling property as a result of a slightly low Ths which led to a smaller nZD as shown in Table.

(Example 5)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially oriented polyethylene terephthalate film suggested that it had characteristics including good curling property as a result of slightly low Ths and Ta which led to a smaller nZD as shown in Table.

(Example 6)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially oriented polyethylene terephthalate film suggested that it had characteristics including high thermal dimensional stability as a result of a slightly high degree of relaxation (occasionally referred to as Rxa) which led to a smaller value of (nMD + nTD / 2) as shown in Table.

(Example 7)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially oriented polyethylene terephthalate film suggested that it had characteristics including slightly low thermal dimensional stability as a result of a slightly large Rxa and slightly high Ths and Ta which led to a smaller value of (nMD + nTD / 2) as shown in Table.

(Example 8)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including slightly low thermal dimensional stability as a result of a slightly large Rxa and a slightly high Ths which led to a smaller value of (nMD + nTD / 2) as shown in Table.

(Example 9)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including high thermal dimensional stability as a result of a slightly large Rxa and a slightly low Ths which led to a smaller value of (nMD + nTD / 2) as shown in Table.

(Example 10)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including high thermal dimensional stability as a result of a slightly large Rxa and slightly low Ths and Ta which led to a smaller value of (nMD + nTD / 2) as shown in Table.

(Example 11)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including good curling property as a result of a slightly small Rxa which led to a smaller nZD as shown in Table.

(Example 12)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including considerably high thermal dimensional stability and curling property as a result of a slightly high Ta, in spite of a slightly small Rxa.

(Example 13)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including good curling property as a result of a slightly small Rxa and a slightly low Ta which led to a smaller nZD as shown in Table.

(Example 14)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including high thermal dimensional stability as a result of a slightly small Rxa and a slightly high Ths which led to a smaller value of (nMD + nTD / 2) as shown in Table.

(Example 15)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including high thermal dimensional stability as a result of a slightly small Rxa and a slightly high Ths which led to a smaller value of (nMD + nTD / 2) as shown in Table.

(Example 16)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including high thermal dimensional stability as a result of a slightly small Rxa and a slightly high Ths which led to a smaller value of (nMD + nTD / 2) as shown in Table.

(Example 17)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including slightly poor curling property as a result of a slightly small Rxa and a slightly low Ths which led to a smaller nZD as shown in Table.

(Example 18)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including slightly poor curling property as a result of a slightly small Rxa and a slightly low Ths which led to a smaller nZD as shown in Table.

(Example 19)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including slightly poor curling property as a result of a slightly small Rxa and slightly low Ths and Ta which led to a smaller nZD as shown in Table.

(Example 20)

Except that the heat treatment, performed before transverse stretching, was conducted at a temperature of 90°C, the same procedure as in Example 1 was carried out to provide a biaxially stretched polyethylene terephthalate film. Evaluation of the resulting biaxially orientated polyethylene terephthalate film suggested that it had characteristics including high thermal  dimensional stability as a result of a smaller number of crystallites formed before transverse stretching and a smaller effect of nodal points which led to a smaller value of (nMD + nTD / 2) as shown in Table.

(Example 21)

Except that the longitudinal draw ratio, transverse draw ratio, and temperature of heat treatment preceding the transverse stretching were set to 3.1, 3.8, and 100°C; respectively, the same procedure as Example 1 was carried out to provide a biaxially stretched polyethylene terephthalate film. Evaluation of the resulting biaxially orientated polyethylene terephthalate film suggested that it had characteristics including slightly poor thermal dimensional stability as a result of low draw ratios which led to a smaller value of (nMD + nTD / 2) as shown in Table.

(Comparative example 1)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including poor curling property as a result of a Rxa of zero which led to an nZD outside the specified range as shown in Table.

(Comparative example 2)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including poor curling property as a result of a Rxa of zero which led to an nZD outside the specified range as shown in Table.

(Comparative example 3)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including poor curling property as a result of a Rxa of zero which led to an nZD outside the specified range as shown in Table.

(Comparative example 4)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including poor curling property  as a result of a Rxa of zero which led to an nZD outside the specified range as shown in Table.

(Comparative example 5)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including poor curling property as a result of a Rxa of zero which led to an nZD outside the specified range as shown in Table.

(Comparative example 6)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including poor curling property as a result of a Rxa of zero which led to an nZD outside the specified range as shown in Table.

(Comparative example 7)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including poor curling property as a result of a Rxa of zero which led to an nZD outside the specified range as shown in Table.

(Comparative example 8)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including poor curling property as a result of a Rxa of zero which led to an nZD outside the specified range as shown in Table.

(Comparative example 9)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including poor curling property as a result of a Rxa of zero which led to an nZD outside the specified range as shown in Table.

(Comparative example 10)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including poor thermal dimensional stability as a result of too high a Ta which led to a value of (nMD + nTD / 2) outside the specified range as shown in Table.

(Comparative example 11)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including poor thermal dimensional stability as a result of too high a Ths which led to values of (nMD + nTD / 2) and nZD outside the specified range as shown in Table.

(Comparative example 12)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including poor curling property as a result of too low a Ths which led to an nZD outside the specified range as shown in Table.

(Comparative example 13)

Except that heat fixation treatment conditions and relaxed annealing treatment conditions as shown in Table 1 were used, the same procedure as in Example 1 was carried out to provide a biaxially orientated polyethylene terephthalate film. Evaluation of the resulting biaxially orientated polyethylene terephthalate film suggested that it had characteristics including poor curling property as a result of too low a Ta which led to an nZD outside the specified range as shown in Table.

The film production conditions, film properties, and evaluation results in Examples 1 to 19 and Comparative examples 1 to 13 are listed in Table 1.

[Table 1-1]

[Table 1-1]

| | Heat treatment conditions for film production | | Relaxed annealing conditions | | Physical properties | | | | | | | | | | |
|---|---|---|---|---|---|---|---|---|---|---|---|---|---|---|---|
| | heat treatment temperature Ths [°C] | degree of relaxation Rxhs [%] | annealing temperature Ta [°C] | degree of relaxation Rxa [%] | (nMD+nTD)/2 | right side of equation 1 | nZD | fn | minor melting peak T-meta [°C] | thermal expansion coefficient [ppm/°C] MD | thermal expansion coefficient [ppm/°C] TD | heat shrinkage at 150°C [%] MD | heat shrinkage at 150°C [%] TD | degree of crystallinity (Xc) | fn/Xc |
| Example 1 | 190 | 2 | 180 | 1 | 1.6629 | 1.4957 | 1.4997 | 0.1632 | 190 | 17 | 17 | 0.2 | 0.2 | 0.29 | 0.57 |
| Example 2 | 200 | 2 | 195 | 1 | 1.6583 | 1.4993 | 1.5050 | 0.1533 | 200 | 23 | 23 | 0.0 | 0.0 | 0.32 | 0.47 |
| Example 3 | 200 | 2 | 185 | 1 | 1.6606 | 1.4975 | 1.5037 | 0.1569 | 200 | 20 | 20 | 0.1 | 0.1 | 0.31 | 0.51 |
| Example 4 | 180 | 2 | 175 | 1 | 1.6644 | 1.4944 | 1.4956 | 0.1688 | 180 | 15 | 15 | 0.4 | 0.4 | 0.29 | 0.59 |
| Example 5 | 180 | 2 | 165 | 1 | 1.6652 | 1.4938 | 1.4943 | 0.1709 | 180 | 14 | 14 | 0.5 | 0.5 | 0.28 | 0.60 |
| Example 6 | 190 | 2 | 180 | 3 | 1.6583 | 1.4993 | 1.5050 | 0.1533 | 190 | 23 | 23 | 0.0 | 0.0 | 0.32 | 0.47 |
| Example 7 | 200 | 2 | 195 | 3 | 1.6568 | 1.5006 | 1.5190 | 0.1378 | 200 | 25 | 25 | 0.0 | 0.0 | 0.33 | 0.42 |
| Example 8 | 200 | 2 | 185 | 3 | 1.6575 | 1.5000 | 1.5151 | 0.1424 | 200 | 24 | 24 | 0.0 | 0.0 | 0.33 | 0.44 |
| Example 9 | 180 | 2 | 175 | 3 | 1.6591 | 1.4987 | 1.5037 | 0.1553 | 180 | 22 | 22 | 0.1 | 0.1 | 0.32 | 0.49 |
| Example 10 | 180 | 2 | 165 | 3 | 1.6598 | 1.4981 | 1.4997 | 0.1602 | 180 | 21 | 21 | 0.2 | 0.2 | 0.32 | 0.50 |
| Example 11 | 190 | 2 | 180 | 0.1 | 1.6629 | 1.4957 | 1.4956 | 0.1673 | 190 | 17 | 17 | 0.4 | 0.4 | 0.29 | 0.57 |
| Example 12 | 190 | 2 | 185 | 0.1 | 1.6629 | 1.4957 | 1.4973 | 0.1656 | 190 | 17 | 17 | 0.3 | 0.3 | 0.29 | 0.57 |
| Example 13 | 190 | 2 | 175 | 0.1 | 1.6629 | 1.4957 | 1.4943 | 0.1686 | 190 | 17 | 17 | 0.5 | 0.5 | 0.30 | 0.57 |
| Example 14 | 200 | 2 | 195 | 0.1 | 1.6606 | 1.4975 | 1.5037 | 0.1569 | 200 | 20 | 20 | 0.1 | 0.1 | 0.31 | 0.51 |

| | Heat treatment conditions for film production | | Relaxed annealing conditions | | Physical properties | | | | | | | | | | |
|---|---|---|---|---|---|---|---|---|---|---|---|---|---|---|---|
| | heat treatment temperature | degree of relaxation | annealing temperature | degree of relaxation | (nMD+nTD)/2 | right side of equation 1 | nZD | fn | minor melting peak | thermal expansion coefficient | | heat shrinkage at 150°C | | degree of crystallinity (Xc) | fn/Xc |
| | Ths | Rxhs | Ta | Rxa | | | | | T-meta [°C] | [ppm/°C] | | [%] | | | |
| | [°C] | [%] | [°C] | [%] | | | | | | MD | TD | MD | TD | | |
| Example 15 | 200 | 2 | 190 | 0.1 | 1.6606 | 1.4975 | 1.4997 | 0.1609 | 200 | 20 | 20 | 0.2 | 0.2 | 0.31 | 0.52 |
| Example 16 | 200 | 2 | 185 | 0.1 | 1.6606 | 1.4975 | 1.4973 | 0.1633 | 200 | 20 | 20 | 0.3 | 0.3 | 0.31 | 0.52 |
| Example 17 | 180 | 2 | 175 | 0.1 | 1.6652 | 1.4938 | 1.4924 | 0.1728 | 180 | 14 | 14 | 0.7 | 0.7 | 0.29 | 0.60 |
| Example 18 | 180 | 2 | 170 | 0.1 | 1.6652 | 1.4938 | 1.4916 | 0.1736 | 180 | 14 | 14 | 0.8 | 0.8 | 0.29 | 0.60 |
| Example 19 | 180 | 2 | 165 | 0.1 | 1.6652 | 1.4938 | 1.4909 | 0.1743 | 180 | 14 | 14 | 0.9 | 0.9 | 0.29 | 0.60 |
| Example 20 | 190 | 2 | 180 | 1 | 1.6610 | 1.4972 | 1.5032 | 0.1578 | 190 | 20 | 20 | 0.1 | 0.1 | 0.31 | 0.51 |
| Example 21 | 190 | 2 | 180 | 0.1 | 1.6561 | 1.5011 | 1.5192 | 0.1369 | 190 | 25 | 25 | 0.0 | 0.0 | 0.33 | 0.42 |
| Comparative example 1 | 190 | 2 | 180 | 0 | 1.6629 | 1.4957 | 1.4863 | 0.1766 | 190 | 17 | 17 | 2.0 | 2.0 | 0.30 | 0.58 |
| Comparative example 2 | 190 | 2 | 185 | 0 | 1.6629 | 1.4957 | 1.4872 | 0.1757 | 190 | 17 | 17 | 1.7 | 1.7 | 0.30 | 0.58 |
| Comparative exampla 3 | 190 | 2 | 175 | 0 | 1.6629 | 1.4957 | 1.4855 | 0.1774 | 190 | 17 | 17 | 2.3 | 2.3 | 0.30 | 0.58 |
| Comparative exampk 4 | 200 | 2 | 195 | 0 | 1.6606 | 1.4975 | 1.4899 | 0.1707 | 200 | 20 | 20 | 1.0 | 1.0 | 0.33 | 0.52 |
| Comparative example 5 | 200 | 2 | 190 | 0 | 1.6606 | 1.4975 | 1.4888 | 0.1718 | 200 | 20 | 20 | 1.3 | 1.3 | 0.33 | 0.52 |
| Comparative example 6 | 200 | 2 | 185 | 0 | 1.6606 | 1.4975 | 1.4872 | 0.1734 | 200 | 20 | 20 | 1.7 | 1.7 | 0.33 | 0.52 |

EP 2 679 378 A1

(continued)

| | Heat treatment conditions for film production | | Relaxed annealing conditions | | Physical properties | | | | | | | | | | |
|---|---|---|---|---|---|---|---|---|---|---|---|---|---|---|---|
| | heat treatment temperature | degree of relaxation | annealing temperature | degree of relaxation | (nMD+nTD)/2 | right side of equation 1 | nZD | fn | minor melting peak | thermal expansion coefficient | | heat shrinkage at 150°C | | degree of crystallinity (Xc) | fn/Xc |
| | Ths | Rxhs | Ta | Rxa | | | | | T-meta [°C] | [ppm/°C] | | [%] | | | |
| | [°C] | [%] | [°C] | [%] | | | | | | MD | TD | MD | TD | | |
| Comparative example 7 | 180 | 2 | 175 | 0 | 1.6652 | 1.4938 | 1.4845 | 0.1807 | 180 | 14 | 14 | 2.7 | 2.7 | 0.30 | 0.60 |
| Comparative example 8 | 180 | 2 | 170 | 0 | 1.6652 | 1.4938 | 1.4839 | 0.1813 | 180 | 14 | 14 | 3.0 | 3.0 | 0.30 | 0.60 |
| Comparative example 9 | 180 | 2 | 165 | 0 | 1.6652 | 1.4938 | 1.4836 | 0.1817 | 180 | 14 | 14 | 3.2 | 3.2 | 0.30 | 0.60 |
| Comparative example 10 | 200 | 2 | 200 | 0.1 | 1.6540 | 1.5028 | 1.5084 | 0.1456 | 200 | 26 | 26 | 0.0 | 0.0 | 0.36 | 0.41 |
| Comparative example 11 | 205 | 2 | 195 | 0.1 | 1.6532 | 1.5034 | 1.5096 | 0.1436 | 205 | 27 | 27 | 0.0 | 0.0 | 0.36 | 0.40 |
| Comparative example 12 | 175 | 2 | 165 | 3 | 1.6606 | 1.4975 | 1.4897 | 0.1709 | 175 | 20 | 20 | 1.1 | 1.1 | 0.33 | 0.52 |
| Comparative example 13 | 180 | 2 | 160 | 3 | 1.6598 | 1.4981 | 1.4888 | 0.1711 | 180 | 21 | 21 | 1.3 | 1.3 | 0.33 | 0.51 |

[Table 1-2]

[Table 1-2]

| | Evaluation | | | | | |
|---|---|---|---|---|---|---|
| | Thermal dimensional stability | | | | Curling property | |
| | surface resistivity | evaluation | deformation quantity | evaluation | warp | evaluation |
| | [Ω/□] | | [μm] | | [mm] | |
| Example 1 | 28 | AA | 196 | AA | 1.5 | AA |
| Example 2 | 45 | A | 39 | AA | 3.3 | A |
| Example 3 | 32 | A | 98 | AA | 2.2 | AA |
| Example 4 | 25 | AA | 392 | A | 2.3 | AA |
| Example 5 | 25 | AA | 490 | A | 2.7 | A |
| Example 6 | 45 | A | 39 | AA | 3.3 | A |
| Example 7 | 80 | B | 10 | AA | 4.2 | A |
| Example 8 | 60 | B | 20 | AA | 3.7 | A |
| Example 9 | 40 | A | 98 | AA | 3.3 | A |
| Example 10 | 35 | A | 196 | AA | 3.7 | A |
| Example 11 | 28 | AA | 392 | A | 3.4 | A |
| Example 12 | 28 | AA | 294 | A | 2.4 | AA |
| Example 13 | 28 | AA | 490 | A | 4.4 | A |
| Example 14 | 32 | A | 98 | AA | 2.2 | AA |
| Example 15 | 32 | A | 196 | AA | 3.2 | A |
| Example 16 | 32 | A | 294 | A | 4.1 | A |
| Example 17 | 25 | AA | 686 | B | 4.6 | A |
| Example 18 | 25 | AA | 784 | B | 5.6 | B |
| Example 19 | 25 | AA | 882 | B | 6.6 | B |
| Example 20 | 32 | A | 98 | AA | 2.2 | A |
| Example 21 | 80 | B | 29 | AA | 4.4 | A |
| Comparative example 1 | formation impossible | C | formation impossible | C | 19 | C |
| Comparative example 2 | formation impossible | C | formation impossible | C | 16 | C |
| Comparative example 3 | formation impossible | C | formation impossible | C | 22 | C |
| Comparative example 4 | 32 | A | formation impossible | C | 11 | C |
| Comparative example 5 | 32 | A | formation impossible | C | 14 | C |
| Comparative example 6 | formation impossible | C | formation impossible | C | 18 | C |
| Comparative example 7 | formation impossible | C | formation impossible | C | 24 | C |

(continued)

| | Evaluation | | | | | |
| --- | --- | --- | --- | --- | --- | --- |
| | Thermal dimensional stability | | | | Curling property | |
| | surface resistivity | evaluation | deformation quantity | evaluation | warp | evaluation |
| | [Ω/□] | | [μm] | | [mm] | |
| Comparative example 8 | formation impossible | C | formation impossible | C | 27 | C |
| Comparative example 9 | formation impossible | C | formation impossible | C | 29 | C |
| Comparative example 10 | 105 | C | 34 | AA | 5.0 | B |
| Comparative example 11 | 150 | C | 29 | AA | 5.5 | B |
| Comparative example 12 | 32 | A | formation impossible | C | 12 | C |
| Comparative example 13 | 35 | A | formation impossible | C | 14 | C |

[Industrial applicability]

The biaxially orientated polyethylene terephthalate film according to the present invention can serve as base film for flexible devices having high thermal dimensional stability and curling property. Accordingly, it may be used to produce products such as organic EL display, electronic paper, organic EL lighting, organic solar battery, and dye-sensitized solar battery.

**Claims**

1. Biaxially orientated polyethylene terephthalate film comprising at least polyethylene terephthalate resin and **characterized in that** the average, ((nMD + nTD) / 2), of the refractive index in the length direction of the film, nMD, and the refractive index in its width direction, nTD, is 1.655 to 1.70 and that the refractive index in the thickness direction, nZD, is 1.490 to 1.520.

2. Biaxially orientated polyethylene terephthalate film as described in claim 1 wherein the relationship among the refractive indices in the length, width, and thickness directions of the film is as represented by the following equation:

$$\text{Equation 1} \qquad nZD \geq -0.8 \times ((nMD + nTD) / 2) + 2.826$$

3. Biaxially orientated polyethylene terephthalate film as described in either claim 1 or 2 wherein both the degree of thremal shrinkage in the length direction of the film and that in its width direction are 0 to 0.5% at a temperature of 150°C.

4. Biaxially orientated polyethylene terephthalate film as described in any of claims 1 to 3 wherein both the coefficient of thermal expansion in the length direction of the film and that in its width direction are 0 to 25 ppm/°C in the temperature range of 50 to 150°C.

5. Biaxially orientated polyethylene terephthalate film as described in any of claims 1 to 4 wherein a minor melting peak (T-meta) appears at a temperature of 180 to 200°C.

6. Biaxially orientated polyethylene terephthalate film as described in any of claims 1 to 5 wherein the ratio of the in-plane orientation coefficient (fn), which is determined from the refractive index in the length direction of the film, nMD, refractive index in its width direction, nTD, and refractive index in the thickness direction of the film, nZD, to the degree of crystallinity (Xc) is 0.45 to 0.65.

7. Biaxially orientated polyethylene terephthalate film as described in any of claims 1 to 6 wherein the degree of crystallinity (Xc) is 0.25 to 0.35.

8. Biaxially orientated polyethylene terephthalate film as described in any of claims 1 to 7 wherein the haze of the film is 0 to 5%.

9. Base film for flexible devices, comprising biaxially orientated polyethylene terephthalate film as described in any of claims 1 to 8.

| | |
|---|---|
| **INTERNATIONAL SEARCH REPORT** | International application No. |
| | PCT/JP2012/053763 |

**A. CLASSIFICATION OF SUBJECT MATTER**
*B29C55/12*(2006.01)i, *H05K1/03*(2006.01)i, *B29K67/00*(2006.01)n, *B29L7/00* (2006.01)n

According to International Patent Classification (IPC) or to both national classification and IPC

**B. FIELDS SEARCHED**

Minimum documentation searched (classification system followed by classification symbols)
B29C55/00-55/30, B29C61/00-61/10, C08J5/18, B32B1/00-43/00, H05K1/03, B29K67/00, B29L7/00

Documentation searched other than minimum documentation to the extent that such documents are included in the fields searched
Jitsuyo Shinan Koho          1922-1996    Jitsuyo Shinan Toroku Koho    1996-2012
Kokai Jitsuyo Shinan Koho    1971-2012    Toroku Jitsuyo Shinan Koho    1994-2012

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 03-137814 A  (Diafoil Co., Ltd.),<br>12 June 1991 (12.06.1991),<br>claims; page 2, lower right column, line 20<br>to page 3, upper left column, line 7; page 4,<br>upper left column, line 12 to page 5, upper<br>left column, line 11; table 1<br>& US 5087526 A          & EP 424884 A2<br>& DE 69015315 C          & DE 69015315 D | 1-5,8<br>6,7,9 |
| X<br>Y<br>A | JP 2000-186161 A  (Toray Industries, Inc.),<br>04 July 2000 (04.07.2000),<br>paragraphs [0040], [0053] to [0058]<br>(Family: none) | 1,2,5,8<br>6,7,9<br>3,4 |

| | | | |
|---|---|---|---|
| ☒ Further documents are listed in the continuation of Box C. | | ☐ See patent family annex. | |

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 01 May, 2012 (01.05.12) | 22 May, 2012 (22.05.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

| International application No. |
| --- |
| PCT/JP2012/053763 |

C (Continuation).   DOCUMENTS CONSIDERED TO BE RELEVANT

| Category* | Citation of document, with indication, where appropriate, of the relevant passages | Relevant to claim No. |
| --- | --- | --- |
| X<br>Y<br>A | JP 2002-178475 A  (Teijin Ltd.),<br>26 June 2002 (26.06.2002),<br>claim 1; paragraphs [0045], [0057] to [0059]<br>(Family: none) | 1-3,8<br>6,7,9<br>4,5 |
| Y<br>A | JP 2000-143837 A  (Toray Industries, Inc.),<br>26 May 2000 (26.05.2000),<br>paragraphs [0002], [0011]<br>(Family: none) | 6,7<br>1-5,8,9 |
| Y<br>A | JP 2010-225434 A  (Teijin DuPont Films Japan<br>Ltd.),<br>07 October 2010 (07.10.2010),<br>paragraphs [0002] to [0004]<br>(Family: none) | 9<br>1-8 |

Form PCT/ISA/210 (continuation of second sheet) (July 2009)

## INTERNATIONAL SEARCH REPORT

International application No.

PCT/JP2012/053763

| Box No. II | Observations where certain claims were found unsearchable (Continuation of item 2 of first sheet) |

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

| Box No. III | Observations where unity of invention is lacking (Continuation of item 3 of first sheet) |

This International Searching Authority found multiple inventions in this international application, as follows:
    The technical feature common to the inventions of claims 1-9 is biaxially oriented polyethylene terephthalate film according to the invention of claim 1.
(Continued to extra sheet)

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**
☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

| INTERNATIONAL SEARCH REPORT | International application No. |
|---|---|
| | PCT/JP2012/053763 |

Continuation of Box No.III of continuation of first sheet(2)

However, the search revealed that the above-said technical feature cannot be considered to be a special technical feature, since the technical feature does not make a contribution over the prior art in the light of the contents disclosed in the document 1 (JP 03-137814 A (Diafoil Co., Ltd.), 12 June 1991 (12.06.1991)), the document 2 (JP 2000-186161 A (Toray Industries, Inc.), 04 July 2000 (04.07.2000)) and the document 3 (JP 2002-178475 A (Teijin Ltd.), 26 June 2002 (26.06.2002)).

Further, the inventions of claims 1-9 have no other same or corresponding technical feature.

Form PCT/ISA/210 (extra sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003101166 A
- JP 2004035720 A
- JP HEI367627 B
- JP HEI10217410 B
- JP 2002307550 A